# EUROPEAN PATENT APPLICATION

(11) **EP 1 632 794 A2**
(43) Date of publication of application: **08.03.2006**
(21) Application number: 05014869.1
(22) Date of filing: 08.07.2005
(51) Int. Cl.: G02B 1/04

(54) **Radiation sensitive resin composition for forming microlens**

(30) Priority: 09.07.2004 JP 2004203911
(71) Applicant: JSR Corporation, Tokyo 104-0045 (JP)
(72) Inventor: Hanamura, Masaaki, Tokyo 104-0045 (JP)
(74) Representative: TBK-Patent

(57) **Abstract**

A radiation sensitive resin composition which contains (A) an alkali soluble polymer of a polymerizable mixture containing (a) 10 to 50 wt% of polymerizable unsaturated compound having an acid functional group, (b) 20 to 60 wt% of polymerizable unsaturated compound having an alicyclic hydrocarbon group and no acid functional group, and (c) 5 to 40 wt% of other polymerizable unsaturated compound, said wt% being based on the total of these components (a), (b) and (c),
(B) a polymerizable unsaturated compound,
(C) a photopolymerization initiator, and
(D) a thermal polymerizable compound. The composition is used for forming a microlens.

## Description

### BACKGROUND OF THE INVENTION

### Field of the Invention

This invention relates to a radiation sensitive resin composition for forming a microlens, a microlens formed from the composition, a method for forming the microlens, and a liquid crystal display device comprising the microlens.

### Description of the Related Art

In recent years, liquid crystal display devices are the most widely used among flat panel displays due to excellent characteristics such as high-definition display performance, low power consumption, high reliability, high adaptability to any size, a small thickness and a light weight. Along with widespread use of OA equipment such as a personal computer and a word processor, liquid crystal televisions, portable telephones and projectors, demands for higher-definition display performance and lower power consumption of the liquid crystal display devices have been becoming increasingly stringent.

To meet these demands, there are proposed methods of improving the brightness and contrast of a liquid crystal display device by providing a microlens array to collect light emitted from an external source or backlight to the opening (refer to JP-A 2001-154181, JP-A 2001-117114, JP-A 11-109417 and JP-A 10-268305). In these methods, it is often necessary to make large the difference in refractive index between a material forming the microlens and a flattened film and to control the curvature radius of the lens precisely because the focal distance from a light collecting layer having the microlens to the opening of a liquid crystal pixel is short.

Illustrative examples of a method of forming such a microlens for a liquid crystal display device include a method comprising dry-etching a glass substrate to form a hollow and filling the hollow with a high-refractive-index ultraviolet curable resin, a method comprising forming a lens pattern, melt-flowing the pattern by a heat treatment and using the resulting product as a lens as it is, and a method comprising forming a pattern from a radiation sensitive resin composition, melt-flowing the pattern to prepare a mask of predetermined pattern, and carrying out dry-etching through this mask to transfer a predetermined lens shape to a substrate. However, in all of these methods, a microlens formation process is complicated and costly and cannot be said to be satisfactory from an industrial standpoint.

Consequently, development of a radiation sensitive resin composition which can satisfy various properties required for a microlens, e.g., a film thickness, a resolution, a pattern shape, transparency, heat resistance and solvent resistance, has good storage stability and can form a microlens by a simple and easy method is strongly desired.

Further, along with an increase in use of the liquid crystal display device in recent years, demands for reductions in the weight and production cost of the liquid crystal display device have been increasing.

Therefore, an attempt to use a resin substrate in place of conventionally used glass as disclosed in JP-A 2000-10087 has been made, and to avoid deformation and yellowing of the resin substrate, developments of a radiation sensitive resin composition and a method which are capable of forming a microlens as low heating temperatures have been strongly desired.

Further, most of methods for forming a microlens for a liquid crystal display device that uses a radiation sensitive resin composition comprise a step of forming a coating film on a substrate by applying a resin composition containing an organic solvent by a method such as spin coating, dipping or spraying. In the case of such methods, time to determine conditions for obtaining a predetermined film thickness is required, and an environmental problem such as evaporation of organic solvent is pointed out.

Thus, development of a method for forming a microlens without environmental problems and in a shorter time and at a lower cost than conventional methods for forming a microlens has also been desired.

### SUMMARY OF THE INVENTION

The present invention has been conceived in view of the above circumstances. An object of the present invention is to provide a radiation sensitive resin composition for forming a microlens which can form a microlens having an excellent film thickness, resolution, pattern shape, transparency, heat resistance, thermal discoloration resistance and solvent resistance and has good storage stability.

Another object of the present invention is to provide a method which can form a microlens having the above excellent properties by a simple process which includes use of a radiation sensitive dry film and even with a low-temperature heat treatment.

Still another object of the present invention is to provide a liquid crystal display device comprising the microlens.

Firstly, the present invention comprises a radiation sensitive resin composition for forming a microlens that comprises:
(A) an alkali soluble copolymer comprising:
   (a) 10 to 50 wt% of polymerizable unsaturated compound having an acid functional group,
   (b) 20 to 60 wt% of polymerizable unsaturated compound having an alicyclic hydrocarbon group and no acid functional group, and
   (c) 5 to 40 wt% of other polymerizable unsaturated compound (provided that (a) + (b) + (c) = 100 wt%),
(B) a polymerizable unsaturated compound,
(C) a photopolymerization initiator, and
(D) a thermal polymerizable compound.

The term "radiation" used in the present invention includes ultraviolet radiation, far ultraviolet radiation, an X-ray, an electron beam, a molecular beam, a gamma ray, synchrotron radiation, a proton beam, and the like.

Secondly, the present invention comprises a microlens formed from the above radiation sensitive resin composition.

Thirdly, the present invention comprises a radiation sensitive dry film formed by laminating a radiation sensitive layer comprising the radiation sensitive resin composition as described above on a base film.

Fourthly, the present invention comprises a method for forming a microlens which carries out the following steps (i) to (iv) in the following order in which they are presented:
(i) forming a coating film of the radiation sensitive resin composition as described above on a substrate,
(ii) irradiating at least a portion of the coating film with radiation,
(iii) developing the irradiated coating film, and
(iv) baking the developed coating film to produce a microlens.

Fifthly, the present invention comprises the above fourth method, wherein the temperature of the heat treatment in the step (iv) is 160°C or lower.

Sixthly, the present invention comprises the above fourth or fifth method, wherein in the step (i), the radiation sensitive layer of the radiation sensitive dry film of the above third item is transferred onto the substrate to form the coating film of the radiation sensitive resin composition on the substrate.

Seventhly, the present invention comprises a liquid crystal display device comprising the above microlens.

### BRIEF DESCRIPTION OF THE DRAWINGS

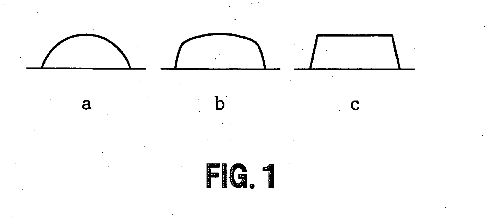

Fig. 1 is a schematic cross-sectional diagram showing three pattern shapes.

### DETAILED DESCRIPTION OF THE PREFERRED EMBODIMENTS

Hereinafter, the present invention will be further described.

### Radiation Sensitive Resin Composition

### - Copolymer (A) -

The component (A) in the present invention comprises an alkali soluble copolymer (hereinafter referred to as "copolymer (A)") of a polymerizable mixture comprising:
(a) 10 to 50 wt% of polymerizable unsaturated compound (hereinafter referred to as "polymerizable unsaturated compound (a)") having an acid functional group,
(b) 20 to 60 wt% of polymerizable unsaturated compound (hereinafter referred to as "polymerizable unsaturated compound (b)") having an alicyclic hydrocarbon group and no acid functional group, and
(c) 5 to 40 wt% of other polymerizable unsaturated compound (provided that (a) + (b) + (c) = 100 wt%).

Illustrative examples of the acid functional group in the polymerizable unsaturated compound (a) include a carboxyl group and a sulfonic group, preferably a carboxyl group.

Illustrative examples of a polymerizable unsaturated compound (a) (hereinafter referred to as "polymerizable unsaturated compound (a1)") having a carboxyl group include unsaturated monocarboxylic acids such as (meth)acrylic acid, crotonic acid, acrylic acid, or a compound resulting from substituting the α-position of crotonic acid with a haloalkyl group, an alkoxyl group, a halogen atom, a nitro group or a cyano group; unsaturated dicarboxylic acids such as maleicacid,maleicanhydride,fumaric acid,citraconic acid, mesaconic acid and itaconic acid, and acid anhydrides thereof; unsaturated dicarboxylic acid half esters resulting from substituting a hydrogen atom in a carboxyl group in the above unsaturated dicarboxylic acid with a methyl group, an ethyl group, an n-propyl group, an i-propyl group, an n-butyl group, a sec-butyl group, a t-butyl group, a phenyl group, an o-tolyl group, an m-tolyl group or a p-tolyl group; unsaturated dicarboxylic acid half amides resulting from substituting a carboxyl group in the above unsaturated dicarboxylic acid with an amide group; and carboxyl-group-containing (meth)acrylic esters such as a monoesterified product of 2-hydroxyethyl (meth)acrylate and succinic acid, a monoesterified product of 2-hydroxyethyl (meth)acrylate and maleic acid, and a monoesterified product (hereinafter referred to as "2-mono(hexahydrophthaloyloxy)ethyl(meth)acrylate") of 2-hydroxyethyl (meth)acrylate and hexahydrophthalic acid.

Of these polymerizable unsaturated compounds (a1), (meth)acrylic acid and 2-mono(hexahydrophthaloyloxy)ethyl(meth)acrylate are more preferred.

In the present invention, the polymerizable unsaturated compounds (a) can be used alone or in admixture of two or more. Particularly, (meth)acrylic acid and 2-mono(hexahydrophthaloyloxy)ethyl(meth)acrylate are preferably used in combination.

The content of the polymerizable unsaturated compound (a) in the polymerizable mixture for the copolymer (A) is 10 to 50 wt%, preferably 20 to 40 wt%. In this case, when the content of the polymerizable unsaturated compound (a) is lower than 10 wt%, the copolymer to be obtained is not easily dissolved in an alkali developer and portions of a film remain after development, so that a satisfactory resolution cannot be obtained, while when the content of the polymerizable unsaturated compound (a) is higher than 50 wt%, the solubility of the copolymer to be obtained in an alkali developer becomes so high that a film reduction in a portion irradiated with radiation becomes large.

Illustrative examples of the polymerizable unsaturated compound (b) include cyclohexyl (meth)acrylate, 2-methylcyclohexyl (meth)acrylate, isobornyl (meth)acrylate, tricyclo[5.2.1.0^{2.6}]decan-8-yl(meth)acrylate(said to be dicyclopentanyl (meth)acrylate as a common name in the art, adamanthyl (meth)acrylate, and 2-dicyclopentanyloxy ethyl (meth)acrylate.

Of these polymerizable unsaturated compounds (b), dicyclopentanyl (meth)acrylate is particularly preferred.

In the present invention, the polymerizable unsaturated compounds (b) can be used alone or in admixture of two or more.

The content of the polymerizable unsaturated compound (b) in the polymerizable mixture for the copolymer (A) is 20 to 60 wt%, preferably 30 to 50 wt%. In this case, when the content of the polymerizable unsaturated compound (b) is lower than 20 wt%, the molecular weight of the copolymer to be obtained does not reach a satisfactorily high level, so that formation of a coating film having a film thickness of not smaller than 10 µm becomes difficult, while when it is higher than 60 wt%, the solubility of the copolymer to be obtained in a solvent or an organic solvent is low.

The other polymerizable unsaturated compound (c) is used primarily for controlling the mechanical properties of the copolymer (A).

Illustrative examples of the other polymerizable unsaturated compound (c) include (meth)acrylic esters, unsaturated dicarboxylic acid diesters presented above as examples of the above polymerizable unsaturated compound (a), aromatic vinyl compounds, conjugated diolefins, nitrile-group-containing unsaturated compounds, chlorine-containing unsaturated compounds, amide-bond-containing unsaturated compounds, and fatty acid vinyl esters.

More specific examples of the other polymerizable unsaturated compound (c) include (meth)acrylic esters such as methyl (meth)acrylate, ethyl (meth)acrylate, n-propyl (meth)acrylate, i-propyl (meth)acrylate, n-butyl (meth)acrylate, sec-butyl (meth)acrylate, t-butyl (meth)acrylate, n-pentyl (meth)acrylate, neopentyl (meth)acrylate, 4-i-pentylhexyl (meth)acrylate, allyl (meth)acrylate, propargyl (meth)acrylate, phenyl (meth)acrylate, naphthyl (meth)acrylate, anthracenyl (meth)acrylate, anthraquinonyl (meth)acrylate, piperonyl (meth)acrylate, salicyl (meth)acrylate, benzyl (meth)acrylate, phenethyl (meth)acrylate, cresyl (meth)acrylate, glycidyl (meth)acrylate, triphenylmethyl (meth)acrylate, cumyl (meth)acrylate, 2,2,2-trifluoroethyl (meth)acrylate, pentafluoroethyl (meth)acrylate, heptafluoro-n-propyl (meth)acrylate, heptafluoro-i-propyl (meth)acrylate, 2-(N,N-dimethylamino)ethyl (meth)acrylate, 3-(N,N-dimethylamino)propyl (meth)acrylate, furyl (meth)acrylate, furfuryl (meth)acrylate, tetrahydrofurfuryl (meth)acrylate, α-(meth)acryloyloxy-γ-butyrolactone, and β-(meth)acryloyloxy-γ-butyrolactone; unsaturated dicarboxylic acid diesters such as dimethyl maleate, diethyl maleate, dimethyl fumarate, diethyl fumarate, dimethyl itaconate, and diethyl itaconate; aromatic vinyl compounds such as styrene, α-methyl styrene, o-methyl styrene, m-methyl styrene, p-methyl styrene, and p-methoxy styrene; conjugated diolefins such as 1,3-butadiene, isoprene, and 2,3-dimethyl-1,3-butadiene; nitrile-group-containing unsaturated compounds such as (meth)acrylonitrile and vinylidene cyanide; chlorine-containing unsaturated compounds such as vinyl chloride and vinylidene chloride; amide-bond-containing unsaturated compounds such as (meth)acrylamide, diamide maleate and diamide fumarate; and fatty acid vinyl esters such as vinyl acetate and vinyl propionate.

Of these other polymerizable unsaturated compounds (c), tetrahydrofurfuryl (meth)acrylate, styrene, 1,3-butadiene and isoprene are preferred.

In the present invention, the other polymerizable unsaturated compounds (c) can be used alone or in admixture of two or more. In particular, combined use of styrene and tetrahydrofurfuryl (meth)acrylate or combined use of styrene and 1,3-butadiene and/or isoprene is preferred.

The content of the other polymerizable unsaturated compound (c) in the polymerizable mixture for the copolymer (A) is 5 to 40 wt%, preferably 10 to 35 wt%.

The weight average molecular weight (hereinafter referred to as "Mw") in terms of polystyrene of the copolymer (A) is preferably 2,000 to 100,000, more preferably 5,000 to 50,000. When the Mw of the copolymer (A) is lower than 2,000, alkali developability, a film remaining rate, a pattern shape and heat resistance may be unsatisfactory, while when it is higher than 100,000, sensitivity and a pattern shape may be unsatisfactory.

Further, the ratio of the Mw to the number average molecular weight (hereinafter referred to as "Mn") in terms of polystyrene of the copolymer (A) (hereinafter referred to as "Mw/Mn") is preferably 1.0 to 5.0, more preferably 1.0 to 3.0.

The copolymer (A) can be produced by polymerizing the polymerizable mixture comprising the polymerizable unsaturated compound (a), the polymerizable unsaturated compound (b) and the other polymerizable unsaturated compound (c) in an appropriate solvent in the presence of a radical polymerization initiator.

Illustrative examples of the solvent used in the above polymerization include alcohols such as methanol, ethanol and diacetone alcohol; ethers such as tetrahydrofuran, tetrahydropyran and dioxane; ethylene glycol alkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; diethylene glycol alkyl ethers such as diethylene glycol monomethyl ether, diethylene glycol monoethyl ether, diethylene glycol dimethyl ether, diethylene glycol ethylmethyl ether, and diethylene glycol diethyl ether; propylene glycol monoalkyl ethers such as propylene glycol monomethyl ether, propylene glycol monoethyl ether, propylene glycol mono-n-propyl ether, and propylene glycol mono-n-butyl ether; propylene glycol monoalkyl ether acetates such as propylene glycol monomethyl ether acetate, propylene glycol monoethyl ether acetate, propylene glycol mono-n-propyl ether acetate, and propylene glycol mono-n-butyl ether acetate; propylene glycol monoalkyl ether propionates such as propylene glycol monomethyl ether propionate, propylene glycol ethyl monoether propionate, propylene glycol mono-n-propyl ether propionate, and propylene glycol mono-n-butyl ether propionate; aromatic hydrocarbons such as toluene and xylene; ketones such as methyl ethyl ketone, methyl isobutyl ketone, 2-heptanone, cyclohexanone, and 4-hydroxy-4-methyl-2-pentanone; and esters such as methyl acetate, ethyl acetate, n-propyl acetate, n-butyl acetate, methyl hydroxyacetate, ethyl hydroxyacetate, n-propyl hydroxyacetate, n-butyl hydroxyacetate, methyl lactate, ethyl lactate, n-propyl lactate, n-butyl lactate, methyl 3-hydroxypropionate, ethyl 3-hydroxypropionate, n-propyl 3-hydroxypropionate, n-butyl 3-hydroxypropionate, methyl 2-hydroxy-2-methyl propionate, ethyl 2-hydroxy-2-methyl propionate, methyl 2-hydroxy-3-methyl butanoate, methyl methoxyacetate, ethyl methoxyacetate, n-propyl methoxyacetate, n-butyl methoxyacetate, methyl ethoxyacetate, ethyl ethoxyacetate, n-propyl ethoxyacetate, n-butyl ethoxyacetate, methyl n-propoxyacetate, ethyl n-propoxyacetate, n-propyl n-propoxyacetate, n-butyl n-propoxyacetate, methyl n-butoxyacetate, ethyl n-butoxyacetate, n-propyl n-butoxyacetate, n-butyl n-butoxyacetate, methyl 2-methoxypropionate, ethyl 2-methoxypropionate, n-propyl 2-methoxypropionate, n-butyl 2-methoxypropionate, methyl 2-ethoxypropionate, ethyl 2-ethoxypropionate, n-propyl 2-ethoxypropionate, n-butyl 2-ethoxypropionate, methyl 2-n-propoxypropionate, ethyl 2-n-propoxypropionate, n-propyl 2-n-propoxypropionate, n-butyl 2-n-propoxypropionate, methyl 2-n-butoxypropionate, ethyl 2-n-butoxypropionate, n-propyl 2-n-butoxypropionate, n-butyl 2-n-butoxypropionate, methyl 3-methoxypropionate, ethyl 3-methoxypropionate, n-propyl 3-methoxypropionate, n-butyl 3-methoxypropionate, methyl 3-ethoxypropionate, ethyl 3-ethoxypropionate, n-propyl 3-ethoxypropionate, n-butyl 3-ethoxypropionate, methyl 3-n-propoxypropionate, ethyl 3-n-propoxypropionate, n-propyl 3-n-propoxypropionate, n-butyl 3-n-propoxypropionate, methyl 3-n-butoxypropionate, ethyl 3-n-butoxypropionate, n-propyl 3-n-butoxypropionate, and n-butyl 3-n-butoxypropionate.

These solvents can be used alone or in admixture of two or more.

Meanwhile, illustrative examples of the above radical polymerization initiator include azo compounds such as 2,2'-azobisisobutyronitrile, 2,2'-azobis-(2,4-dimethylvaleronitrile) and 2,2'azobis(4-methoxy-2,4-dimethylvaleronitrile; and organic peroxides and hydrogen peroxides such as benzoyl peroxide, lauroyl peroxide, t-butyl peroxypivalate, and 1,1'-bis-(t-butylperoxy)cyclohexane. When a peroxide is used as the radical polymerization initiator, it may be used in combination with a reducing agent so as to be used as a redox type initiator.

In the present invention, the copolymers (A) can be used alone or in admixture of two or more.

### - Polymerizable Unsaturated Compound (B) -

The polymerizable unsaturated compound (B) in the present invention is a compound which polymerizes by irradiation of radiation in the presence of the photopolymerization initiator (C).

Illustrative examples of the polymerizable unsaturated compound (B) include a compound having one ethylenically unsaturated bond, a compound having two ethylenically unsaturated bonds, and a compound having three or more ethylenically unsaturated bonds.

The above compound having one ethylenically unsaturated bond may be, for example, mono(meth)acrylate of monohydric alcohol, preferably a compound represented by the following formula (1). 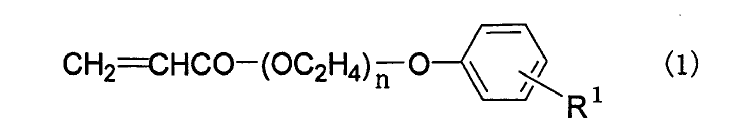 In the formula (1), n represents an integer of 0 to 8, and R¹ represents a hydrogen atom or a linear, branched or cyclic alkyl group having 1 to 9 carbon atoms.

Specific examples of the compound represented by the formula (1) include, under trade names, ARONIX M-101 (n = about 2, R¹ = H), ARONIX M-102 (n = about 4, R¹ = H), ARONIX M-111 (n = about 1 , R¹ = n-C₉H₁₉ (n-nonyl group)), ARONIX M-113 (n = about 4, R¹ = n-C₉H₉) , ARONIX M-114 (n = about 8, R¹ = n-C₉H₁₉) and ARONIX M-117 (n = 2.5 , R¹ = n-C₉H₁₉) (products of TOAGOSEI CO., LTD.), and KAYARAD R-564 (n = about 2.3, R¹ = H) (product of Nippon Kayaku Co., Ltd.).

Illustrative examples of compounds having one ethylenically unsaturated bond other than the compound represented by the formula (1) include, under trade names, KAYARAD TC-110S and KAYARAD TC-120S (products of Nippon Kayaku Co., Ltd.), and V-158 and V-2311 (products of OSAKA ORGANIC CHEMICAL INDUSTRY LTD.).

Further, as compounds having one ethylenically unsaturated bond other than those described above, the same compounds as described above as examples of the polymerizable unsaturated compound (a), the polymerizable unsaturated compound (b) or the other polymerizable unsaturated compound (c) in the copolymer (A), e.g., unsaturated carboxylic acid diesters such as dimethyl maleate and diethyl maleate, can be used.

Further, the above compound having two ethylenically unsaturated bonds may be, for example, di(meth)acrylate of dihydric alcohol, preferably, a compound represented by the following formula (2), a compound represented by the following formula (3) or a compound represented by the following formula (4). 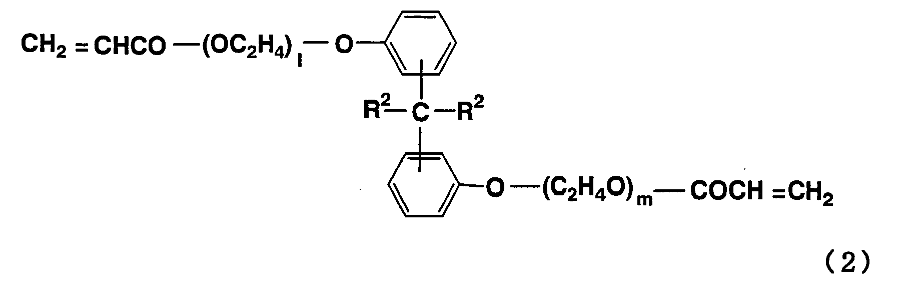 In the formula (2), 1 and m each represent an integer of 0 to 8, and R²s each independently represent a hydrogen atom or a methyl group.

**CH**_{**2**}**=CHCOO―(R**^{**3**}**-O)**_{**p**}**―COCH=CH**_{**2**} **(3)**

In the formula (3), R³ represents a linear or branched alkylene group having 2 to 8 carbon atoms, and p represents an integer of 1 to 10. 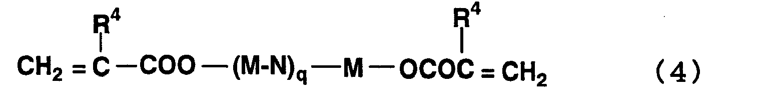 In the formula (4), R⁴s each independently represent a hydrogen atom or a methyl group, M represents a residue of a dihydric alcohol, N represents a residue of a dibasic acid, and q represents 0 or 1.

Specific examples of the compound represented by the formula (2) include, under trade names, ARONIX M- 210 (1 = about 2, m = about 2, R² = CH₃) (product of TOAGOSEI CO., LTD.), and KAYARAD R-551 (1 + m = about 4, R² = CH₃) and KAYARAD R- 712 (1 + m = about 4, R² = H) (products of Nippon Kayaku Co., Ltd.).

Further, specific examples of the compound represented by the formula (3) include, under trade names, ARONIX M-240 (R³ = -CH₂CH₂-, p = about 4) and ARONIX M-245 (R³ = -CH₂CH₂-, p = about 9) (products of TOAGOSEI CO., LTD.), KAYARAD HDDA (R³ = -(CH₂)₆-, p = 1), KAYARAD NPGDA (R³= -CH₂C(CH₃)₂CH₂- , p = 1) , KAYARAD TPGDA (R³ = -CH₂CH(CH₃)-, p = 1) , KAYARAD PEG400DA (R³ = -CH₂CH₂-, p = about 8) and KAYARAD MANDA (R³ = -CH₂C(CH₃)₂CH₂-, p = 1) (product s of Nippon Kayaku Co . , Ltd.), and LITE ACRYLATE 1.9-NDA (R³ = (CH₂) ₈ - p = 1) .

Further, specific examples of the compound represented by the formula (4) include, under trade names, ARONIX M-6100, ARONIX M-6200, ARONIX M-6250, ARONIX M-6300, ARONIX M-6400 and ARONIX M-6500 (products of TOAGOSEI CO., LTD.).

Further, illustrative examples of compounds having two ethylenically unsaturated bonds other than those described above include a compound represented by the following formula (5-1) (KAYARAD HX-220 of Nippon Kayaku Co., Ltd.), a compound represented by the following formula (5-2) (KAYARAD HX-620 of Nippon Kayaku Co. , Ltd.) and, under trade names, R-604 (product of Nippon Kayaku Co. , Ltd.) and V-260, V-312 and V-335HP (products of OSAKA ORGANIC CHEMICAL INDUSTRY LTD.) 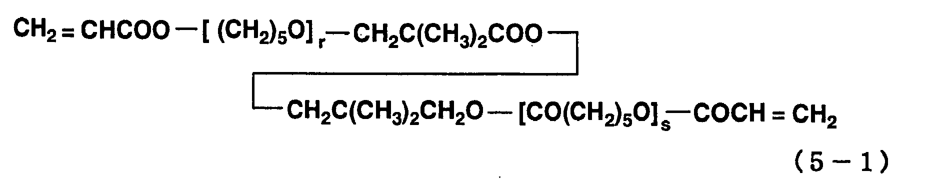 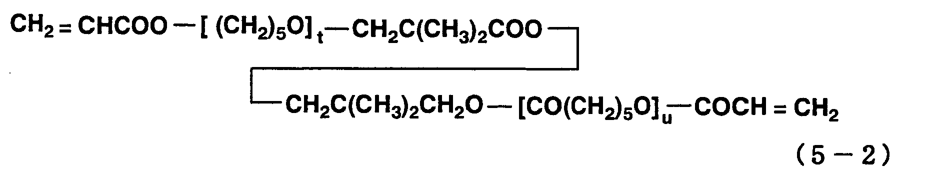 In the formula (5-1), r and s each represent an integer of 0 to 2, and r + s = 2.
In the formula (5-2), t and u each represent an integer of 0 to 4, and t + u = 4.

The above compound having three or more ethylenically unsaturated bonds may be, for example, a poly(meth)acrylate of a polyhydric alcohol having three or more hydroxyl groups, preferably, a compound represented by the following formula (6), a compound represented by the following formula (7), a compound represented by the following formula (8) or a compound represented by the following formula (9).

**[CH**_{**2**}**=CHCO―(OC**_{**3**}**H**_{**6**}**)**_{**v**}**―OCH**_{**2**}**―]**_{**3**}**CCH**_{**2**}**R**^{**5**} **(6)**

In the formula (6), v represents an integer of 0 to 8, and R⁵ represents a hydrogen atom, a hydroxyl group or a methyl group.

(CH₂=CHCOOCH₂)₃CCH₂-R⁶-CH₂C(CH₂OCOCH=CH₂)₃ (7)

In the formula (7), R⁶ represents an oxygen atom or a methylene group. 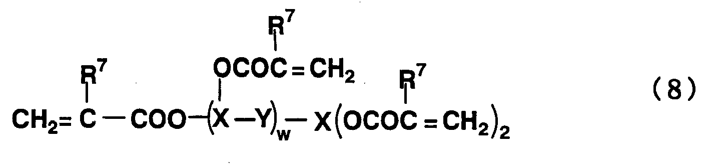 In the formula (8), R⁷s each independently represent a hydrogen atom or a methyl group, X represents a residue of a trihydric alcohol, Y represents a residue of a dibasic acid, and w represents an integer of 0 to 15. 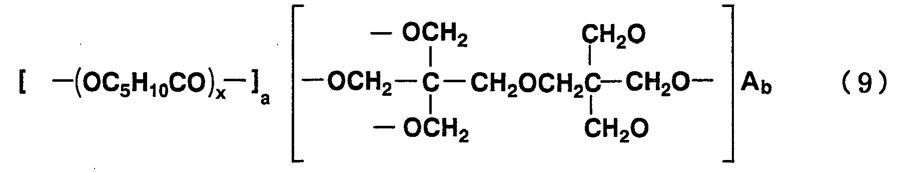 In the formula (9), A represents CH₂=CHCO- , x represents 1 or 2, a represents an integer of 2 to 6, b represents an integer of 0 to 4, and a + b = 6.

Specific examples of the compound represented by the formula (6) include, under trade names, ARONIX M-309 (v = 0, R⁵ = CH₃) and ARONIX M- 310 (v = about 1, R⁵ = CH₃) (products of TOAGOSEI CO., LTD.), KAYARAD TMPTA (v = 0, R⁵ = CH₃) (product of Nippon Kayaku Co . , Ltd.), and V-295 (v = 0, R⁵ = CH₃) and V-300 (v = 0, R⁵ = OH) (products of OSAKA ORGANIC CHEMICAL INDUSTRY LTD.).

Further, specific examples of the compound represented by the formula (7) include, under trade names, ARONIX M-400 (R⁶=Oxygen atom, product of TOAGOSEI CO., LTD.).

Further, specific examples of the compound represented by the formula (8) include, under trade names, ARONIX M-7100, ARONIX M-8030, ARONIX M-8060, ARONIX M-8100 and ARONIX M-9050 (products of TOAGOSEI CO., LTD.).

Further, specific examples of the compound represented by the formula (9) include, under trade names, KAYARAD DPCA-20 (x = about 1, a = about 2, b = about 4), KAYARAD DPCA-30 (x = about 1, a = about 3, b = about 3), KAYARAD DPCA-60 (x = about 1, a = about 6, b = about 0) and KAYARAD DPCA-120 (x = about 2, a = about 6, b = about 0) (products of Nippon Kayaku Co., Ltd.), and V-360, V-GPT, V-3PA and V-400 (products of OSAKA ORGANIC CHEMICAL INDUSTRY LTD.).

Of these polymerizable unsaturated compounds (B) , the compound having two ethylenically unsaturated bonds and the compound having three or more ethylenically unsaturated bonds are preferred. More preferred are the compound represented by the formula (4), the compound represented by the formula (8), and the like.

In the present invention, the polymerizable unsaturated compounds (B) can be used alone or in admixture of two or more.

The polymerizable unsaturated compound (B) in the present invention is preferably used in an amount of 10 to 80 parts by weight, more preferably 30 to 150 parts by weight, yet more preferably 50 to 100 parts by weight, based on 100 parts by weight of the copolymer (A) . In this case, when the amount of the polymerizable unsaturated compound (B) is smaller than 10 parts by weight, sensitivity at the time of irradiation of radiation is liable to deteriorate, while when the amount is larger than 180 parts by weight, compatibility with the copolymer (A) deteriorates, so that the surface of the coating film may be roughened.

### - Photopolymerization Initiator (C) -

The photopolymerization initiator (C) in the present invention is an active species capable of initiating polymerization of the polymerizable unsaturated compound (B) by irradiation of radiation, e.g., a compound which produces a radical.

Illustrative examples of such a photopolymerization initiator (C) include α-diketones such as benzyl and diacetyl; acyloins such as benzoin; acyloin ethers such as benzoin methyl ether, benzoin ethyl ether and benzoin isopropyl ether; thioxanthones such as thioxanthone, 2,4-diethyl thioxanthone and thioxanthone-4-sulfonic acid; benzophenones such as benzophenone, 4,4'- bis(dimethylamino)benzophenone and 4,4'- bis(diethylamino)benzophenone; acetophenones such as acetophenone, p-dimethylamino acetophenone, α,α'-dimethoxyacetoxybenzophenone, 2,2'-dimethoxy-2-phenyl acetophenone, p-methoxyacetophenone, 2-methyl[4-(methylthio)phenyl]-2-morpholinopropane-1-one and 2-benzyl-2-dimethylamino-1-(4-morpholinophenyl) butane-1-one; quinones such as anthraquinone and 1,4-naphthoquinone; halogen compounds such as phenacyl chloride, tribromomethylphenyl sulfone and tris(trichloromethyl)-s-triazine; peroxides such as di-t-butyl peroxide; and acyl phosphine oxides such as 2,4,6-trimethylbenzoyldiphenyl phosphine oxide.

Further, illustrative examples of commercial products of the photopolymerization initiator (C) include, under trade names, IRGACURE 184, IRGACURE 500, IRGACURE 651, IRGACURE 907, IRGACURE CGI369 and IRGACURE CG24-61 (products of Ciba Geigy CO., LTD.), LUCIRIN LR8728 and LUCIRIN TPO (products of BASF CO., LTD.), DALOCURE 1116 and DALOCURE 1173 (products of MELC CO., LTD.), and UBECRYL p36 (product of UCB CO., LTD.).

Of these photopolymerization initiators (C), acetophenones such as 2-methyl[4-(methylthio)phenyl]-2-morpholinopropane-1-one and 2-benzyl-2-dimethylamino-1-(4-morpholinophenyl) butane-1-one, phenacyl chloride, tribromomethylphenyl sulfone, and 2,4,6-trimethylbenzoyldiphenyl phosphine oxide are preferred.

In the present invention, the photopolymerization initiators (C) can be used alone, in admixture of two or more or in combination with a radiation sensitizer.

The photopolymerization initiator (C) in the present invention is preferably used in an amount of 0.01 to 100 parts by weight, more preferably 0.01 to 50 parts by weight, more preferably 0.5 to 40 parts by weight, based on 100 parts by weight of the polymerizable unsaturated compound (B). In this case, when the amount of the photopolymerization initiator (C) is smaller than 0.01 parts by weight, sensitivity may be deteriorated, while when the amount is larger than 100 parts by weight, the photopolymerization initiator (C) is liable to have low compatibility with the copolymer (A) and/or the polymerizable unsaturated compound (B), or a resin composition having low storage stability is liable to be obtained.

### - Thermal Polymerizable Compound (D) -

The thermal polymerizable compound (D) in the present invention is a compound which polymerizes by heating but does not polymerize by irradiation of radiation and is desirably a compound which undergoes thermal polymerization preferably at 80 to 250°C, more preferably at 80 to 160°C, particularly preferably 100 to 150°C.

The thermal polymerizable compound (D) in the present invention is generally a monomer, and its molecular weight is not particularly limited. It may have a molecular weight comparable to that of an oligomer.

Illustrative examples of the thermal polymerizable compound (D) include compounds having one or more thermal polymerizable functional groups, such as an epoxy group, an episulfide group or an oxetanyl group, in a molecule. However, thermal polymerizable compounds (D) having epoxy groups do not include a functional silane coupling agent having an epoxy group, out of adhesion aids to be described later.

Illustrative examples of a compound having one epoxy group out of the thermal polymerizable compounds (D) include glycidyl ethers, e.g., alkyl glycidyl ethers such as methyl glycidyl ether, ethyl glycidyl ether, n-propyl glycidyl ether, i-propyl glycidyl ether, n-butyl glycidyl ether, sec-butyl glycidyl ether and t-butyl glycidyl ether; alkylene glycol monoglycidyl ethers such as ethylene glycol monoglycidyl ether, propylene glycol monoglycidyl ether, 1,4-butanediol monoglycidyl ether and 1,6-hexanediol monoglycidyl ether; polyalkylene glycol monoglycidyl ethers such as polyethylene glycol monoglycidyl ether and polypropylene monoglycidyl ether; and aryl glycidyl ethers such as phenyl glycidyl ether, o-tolyl glycidyl ether, m-tolyl glycidyl ether, p-tolyl glycidyl ether, o-ethylphenyl glycidyl ether, m-ethyl glycidyl ether and p-ethylphenyl glycidyl ether; and compounds having a 3,4-epoxycyclohexyl group, e.g., [(3,4-epoxycyclohexyl)methyl]alkyl ethers such as [(3,4-epoxycyclohexyl)methyl]methyl ether, [(3,4-epoxycyclohexyl)methyl]ethyl ether, [(3,4-epoxycyclohexyl)methyl]n-propyl ether, [(3,4-epoxycyclohexyl)methyl]i-propyl ether, [(3,4-epoxycyclohexyl)methyl]n-butyl ether, [(3,4-epoxycyclohexyl)methyl]sec-butyl ether and [(3,4-epoxycyclohexyl)methyl]t-butyl ether; alkylene glycol mono[(3,4-epoxycyclohexyl)methyl]ethers such as ethylene glycol mono[(3,4-epoxycyclohexyl)methyl]ether, propylene glycol mono[(3,4-epoxycyclohexyl)methyl]ether, 1,4-butanediol mono[(3,4-epoxycyclohexyl)methyl]ether and 1,6-hexanediol mono[(3,4-epoxycyclohexyl)methyl]ether; polyalkylene glycol mono[(3,4-epoxycyclohexyl)methyl]ethers such as polyethylene glycol mono[(3,4-epoxycyclohexyl)methyl]ether and polypropylene glycol mono[(3,4-epoxycyclohexyl)methyl]ether; and [(3,4-epoxycyclohexyl)methyl]aryl ethers such as [(3,4-epoxycyclohexyl)methyl]phenyl ether, [(3,4-epoxycyclohexyl)methyl]o-tolyl ether, [(3,4-epoxycyclohexyl)methyl]m-tolyl ether, [(3,4-epoxycyclohexyl)methyl]p-tolyl ether, [(3,4-epoxycyclohexyl)methyl]o-ethylphenyl ether, [(3,4-epoxycyclohexyl)methyl]m-ethylphenyl ether and [(3,4-epoxycyclohexyl)methyl]p-ethylphenyl ether.

Further, illustrative examples of a compound having two or more epoxy groups include diglycidyl ethers of bisphenol compounds such as bisphenol A diglycidyl ether, bisphenol F diglycidyl ether, bisphenol S diglycidyl ether, hydrogenated bisphenol A diglycidyl ether, hydrogenated bisphenol F diglycidyl ether, hydrogenated bisphenol AD diglycidyl ether, brominated bisphenol A diglycidyl ether, brominated bisphenol F diglycidyl ether and brominated bisphenol S diglycidyl ether; polyglycidyl ethers of polyhydric alcohols such as ethylene glycol diglycidyl ether, propylene glycol diglycidyl ether, 1,4-butanediol diglycidyl ether, 1,6-hexanediol diglycidyl ether, glycerine triglycidyl ether and trimethylolpropane triglycidyl ether; polyalkylene glycol diglycidyl ethers such as polyethylene glycol diglycidyl ether and polypropylene glycol diglycidyl ether; polyglycidyl ethers of polyether polyols obtained by adding one or more alkylene oxides to an aliphatic polyhydric alcohol such as ethylene glycol, propylene glycol or glycerine; bisphenol A type epoxy resins; bisphenol F type epoxy resins; phenol-novolac type epoxy resins; cresol-novolac type epoxy resins; polyphenol type epoxy resins; other alicyclic epoxy resins, other aliphatic polyglycidyl ethers, and polyglycidyl esters of higher polyvalent fatty acids; and epoxidized soybean oil and epoxidized linseed oil. Illustrative examples of the compound having two or more epoxy groups further include, under trade names, EPIKOTE 825, EPIKOTE 828, EPIKOTE 834, EPIKOTE 1001, EPIKOTE 1002, EPIKOTE 1003, EPIKOTE 1004, EPIKOTE 1007, EPIKOTE 1009, EPIKOTE 1010, EPIKOTE 8000 and EPIKOTE 8034 (products of Japan Epoxy Resins Co., Ltd.) as bisphenol A type epoxy resins; EPIKOTE 807 (product of Japan Epoxy Resins Co., Ltd.) as bisphenol F type epoxy resins; EPIKOTE 152, EPIKOTE 154 and EPIKOTE 157S65 (products of Japan Epoxy Resins Co. , Ltd.) and EPPN201 and EPPN202 (products of Nippon Kayaku Co., Ltd.) as phenol-novolac type epoxy resins; EOCN102, EOCN103S, EOCN104S, EOCN1020, EOCN1025 and EOCN1027 (products of Nippon Kayaku Co., Ltd.) and EPIKOTE 180S75 (product of Japan Epoxy Resins Co., Ltd.) as cresol-novolac type epoxy resins; EPIKOTE 1032H60 and EPIKOTE XY-4000 (products of Japan Epoxy Resins Co., Ltd.) as polyphenol type epoxy resins; CY-175, CY-177, CY-179, ARALDITE CY-182, ARALDITE CY-192 and ARALDITE CY-184 (products of Ciba Specialty Chemicals Co., Ltd.) , ERL-4206, ERL-4221, ERL-4234 and ERL-4299 (products of U.C.C.) , SHODINE 509 (product of Showa Denko Co. , Ltd.), EPICLON 200 and EPICLON 400 (products of DAINIPPON INK AND CHEMICALS Inc.), EPIKOTE 871 and EPIKOTE 872 (products of Japan Epoxy Resins Co., Ltd.) and ED-5661 and ED-5662 (products of Celanese Coatings Ltd.) as other alicyclic epoxy resins; and EPOLIGHT 100MF (product of KYOEISHA CHEMICAL Co., LTD.) and EPIOL TMP (product of NOF CORPORATION) as other aliphatic polyglycidyl ethers. Illustrative examples of the compound having two or more epoxy groups further include [(3,4-epoxycyclohexyl)methyl]ester of 3,4-epoxycyclohexanecarboxylic acid, 2-(3,4-epoxycyclohexyl-5,5-spiro-3,4-epoxy) cyclohexane meta-dioxane, bis[(3,4-epoxycyclohexyl)methyl]adipate, bis[(3,4-epoxy-6-methylcyclohexyl)methyl]adipate, (3,4-epoxy-6-methylcyclohexyl)ester of 3,4-epoxy-6-methylcyclohexanecarboxylic acid, methylene bis(3,4-epoxycyclohexane), dicyclopentadiene diepoxide, bis[(3,4-epoxycyclohexyl)methyl]ether of ethylene glycol, bis(3,4-epoxycyclohexanecarboxylic acid)ester of ethylene glycol, and a reaction product of [(3,4-epoxycyclohexyl)methyl]ester of 3,4-epoxycyclohexanecarboxylic acid and caprolactone as compounds having two or more 3,4-epoxycyclohexyl groups; and 1,2:8,9-diepoxylimonene as compounds having an epoxy group and a 3,4-epoxycyclohexyl group.

Further, illustrative examples of a compound having an episulfide group include compounds obtained by substituting an epoxy group (s) in the above compounds having one or more epoxy groups with an episulfide group in accordance with a method disclosed in J. Org. Chem., Vol. 28, p. 229 (1963).

Further, illustrative examples of a compound having an oxetanyl group include 3-methyl-3-methoxymethyloxetane, 3-ethyl-3-methoxymethyloxetane, 3-methyl-3-ethoxymethyloxetane, 3-ethyl-3-ethoxymethyloxetane, 3-methyl-3-hydroxymethyloxetane, 3-ethyl-3-hydroxymethyloxetane, 3-methyl-3-phenoxymethyloxetane, 3-ethyl-3-phenoxymethyloxetane, 3-methyl-3-benzyloxymethyloxetane, 3-ethyl-3-benzyloxymethyloxetane, 3-methyl-3-[(2-ethylhexyloxy)methyl]oxetane, 3-ethyl-3-[(2-ethylhexyloxy)methyl]oxetane, 3-methyl-3-(N-n-butylamidemethoxy)oxetane and 3-ethyl-3-(N-n-butylamidemethoxy)oxetane.

Further, illustrative examples of a compound having two or more oxetane ring skeletons include 3,7-bis(3-oxetanyl)-5-oxanonane, 3,3'-[1,3-(methylenyl)propane-di-yl-bis(oxymethylene)]bis(3-ethyloxetane), 1,4-bis[(3-ethyl-3-oxetanyl)methoxymethyl]benzene, bis[(3-ethyl-3-oxetanyl)methyl]terephthalate, 1,2-bis[(3-ethyl-3-oxetanyl)methoxymethyl]ethane, 1,3-bis[(3-ethyl-3-oxetanyl)methoxymethyl]propane, ethylene glycol bis[(3-ethyl-3-oxetanyl)methyl]ether, diethylene glycol bis[(3-ethyl-3-oxetanyl)methyl]ether, triethylene glycol bis[(3-ethyl-3-oxetanyl)methyl]ether, tetraethylene glycol bis[(3-ethyl-3-oxetanyl)methyl]ether, dicyclopentenyl bis[(3-ethyl-3-oxetanyl)methyl]ether, tricyclodecane-di-yl-dimethylene bis[(3-ethyl-3-oxetanyl)methyl]ether, trimethylolpropane tris[(3-ethyl-3-oxetanyl)methyl]ether, 1,4-bis[(3-ethyl-3-oxetanyl)methoxy]butane, 1,6-bis[(3-ethyl-3-oxetanyl)methoxy]hexane, pentaerythritol tris[(3-ethyl-3-oxetanyl)methyl]ether, pentaerythritol tetrakis[(3-ethyl-3-oxetanyl)methyl]ether, polyethylene glycol bis[(3-ethyl-3-oxetanyl)methyl]ether, dipentaerythritol hexakis[(3-ethyl-3-oxetanyl)methyl]ether, dipentaerythritol pentakis[(3-ethyl-3-oxetanyl)methyl]ether, dipentaerythritol tetrakis[(3-ethyl-3-oxetanyl)methyl]ether, a reaction product of dipentaerythritol hexakis[(3-ethyl-3-oxetanyl)methyl]ether and caprolactone, a reaction product of dipentaerythritol pentakis[(3-ethyl-3-oxetanyl)methyl]ether and caprolactone, ditrimethylolpropane tetrakis[(3-ethyl-3-oxetanyl)methyl]ether, a reaction product of bisphenol A bis[(3-ethyl-3-oxetanyl)methyl]ether and ethylene oxide, a reaction product of bisphenol A bis[(3-ethyl-3-oxetanyl)methyl]ether and propylene oxide, a reaction product of hydrogenated bisphenol A bis[(3-ethyl-3-oxetanyl)methyl]ether and ethylene oxide, a reaction product of hydrogenated bisphenol A bis[(3-ethyl-3-oxetanyl)methyl]ether and propylene oxide, and a reaction product of bisphenol F bis[(3-ethyl-3-oxetanyl)methyl]ether and ethylene oxide.

Of these thermal polymerizable compounds (D), the bisphenol A type epoxy resin, the phenol-novolac type epoxy resin, [(3,4-epoxycyclohexyl)methyl]ester of 3,4-epoxycyclohexanecarboxylic acid, bis[(3-ethyl-3-oxetanyl)methyl]terephthalate and the like are preferred.

In the present invention, the thermal polymerizable compounds (D) can be used alone or in admixture of two or more.

The thermal polymerizable compound (D) in the present invention is preferably used in an amount of 3 to 100 parts by weight, more preferably 5 to 50 parts by weight, based on 100 parts by weight of the copolymer (A). In this case, when the amount of the thermal polymerizable compound (D) is smaller than 3 parts by weight, a desired lens shape may not be obtained, while when the amount is larger than 100 parts by weight, the developability of the resin composition to be obtained may be unsatisfactory.

### - Additives -

To the radiation sensitive resin composition in the present invention, a thermal polymerization inhibitor may be added to inhibit deterioration in developability by overheating at the time of prebaking.

Illustrative examples of such a thermal polymerization inhibitor include pyrogallol, benzoquinone, hydroquinone, methylene blue, t-butyl catechol, methyl hydroquinone, n-amyl quinone, n-amyloyloxy hydroquinone, n-butyl phenol, phenol, hydroquinone mono-n-propyl ether, 4,4'-[1-[4-(1-[4-hydroxyphenyl]-1-methylethyl) phenyl] ethylidene]diphenol, and 1,1,3-tris(2,5-dimethyl-4-hydroxyphenyl)-3-phenylpropane.

These thermal polymerization inhibitors can be used alone or in admixture of two or more.

The thermal polymerization inhibitor is preferably used in an amount of not larger than 5 parts by weight based on 100 parts by weight of the thermal polymerizable compound (D).

To the radiation sensitive resin composition in the present invention, a surfactant may be added to improve coatability, defoamability and levelability.

Illustrative examples of such a surfactant include a fluorine based surfactant, a silicone based surfactant, and a nonionic surfactant.

Illustrative examples of the above fluorine based surfactant include, under trade names, BM-1000 and BM-1100 (products of BM CHIMIE CO., LTD.), MEGAFACE F142D, MEGAFACE F172, MEGAFACE F173 and MEGAFACE F183 (products of DAINIPPON INK AND CHEMICALS Inc.), FLUORAD FC-135, FLUORAD FC-170C, FLUORAD FC-430 and FLUORAD FC-431 (products of Sumitomo 3M Limited), and SURFLON S-112, SURFLON S-113, SURFLON S-131, SURFLON S-141, SURFLON S-145, SURFLON S-382, SURFLON SC-101, SURFLON SC-102, SURFLON SC-103, SURFLON SC-104, SURFLON SC-105 and SURFLON SC-106 (products of ASAHI GLASS CO., LTD.).

Further, illustrative examples of the above silicone based surfactant include, under trade names, SH-28PA, SH-190, SH-193, SZ-6032, SF-8428, DC-57 and DC-190 (products of Toray Dow Corning Silicone Co., Ltd. ) , KP341 (product of Shin-Etsu Chemical Co. , Ltd. ) , and EFTOP EF301, EFTOP EF303 and EFTOP EF352 (products of Shin Akita Kasei Co., Ltd.).

Further, illustrative examples of the above nonionic surfactant include polyoxyethylene alkyl ethers such as polyoxyethylene lauryl ether, polyoxyethylene stearyl ether and polyoxyethylene oleyl ether; polyoxyethylene aryl ethers such as polyoxyethylene n-octylphenyl ether and polyoxyethylene n-nonylphenyl ether; and polyoxyethylene dialkyl esters such as polyoxyethylene dilaurate and polyoxyethylene distearate.

Further, illustrative examples of other surfactants include, under trade names, POLYFLOW No. 57 and POLYFLOW No. 90 (products of KYOEISHA CHEMICAL Co., LTD.)

These surfactants can be used alone or in admixture of two or more.

The surfactant is preferably added in an amount of not larger than 5 parts by weight, more preferably not larger than 2 parts by weight, based on 100 parts by weight of the copolymer (A). In this case, when the amount of the surfactant is larger than 5 parts by weight, film roughening of the coating film is liable to occur during coating.

To the radiation sensitive resin composition in the present invention, an adhesion aid may be added to improve adhesion to a substrate.

As such an adhesion aid, a silane coupling agent having a reactive substituent such as a carboxyl group, a methacryloyl group, a vinyl group, an isocyanate group or an epoxy group is preferred. More specific examples thereof include trimethoxysilylbenzoic acid, γ-methacryloyloxypropyl trimethoxysilane, vinyl triacetoxysilane, vinyl trimethoxysilane, γ-isocyanatepropyl triethoxysilane, γ-glycidoxypropyl trimethoxysilane, and β-(3,4-epoxycyclohexyl)ethyl trimethoxysilane.

These adhesion aids can be used alone or in admixture of two or more.

The adhesion aid is preferably added in an amount of not larger than 20 parts by weight based on 100 parts by weight of the copolymer (A).

To the radiation sensitive resin composition in the present invention, a compound (hereinafter referred to as "carboxylic acid based additive") having a carboxyl group and/or a carboxylic anhydride group may be added to fine-control solubility in an alkali developer.

Illustrative examples of such a carboxylic acid based additive include monocarboxylic acids such as acetic acid, propionicacid, n-butyricacid, isobutyric acid, n-valeric acid, isovaleric acid, benzoic acid and cinnamic acid; hydroxymonocarboxylic acids such as lactic acid, 2-hydroxybutyric acid, 3-hydroxybutyric acid, salicylic acid, m-hydroxybenzoic acid, p-hydroxybenzoic acid, 2-hydroxycinnamic acid, 3-hydroxycinnamic acid, 4-hydroxycinnamic acid, 5-hydroxyisophthalic acid and syringic acid; polycarboxylic acids such as oxalic acid, succinic acid, glutaric acid, adipic acid, maleic acid, itaconic acid, hexahydrophthalic acid, phthalic acid, isophthalic acid, terephthalic acid, 1,2-cyclohexanedicarboxylic acid, 1,2,4-cyclohexanetricarboxylic acid, trimellitic acid, pyromellitic acid, 1,2,3,4-butanetetracarboxylic acid, 1,2,3,4-cyclopentanetetracarboxylic acid and 1,2,5,8-naphthalenetetracarboxylic acid; and acid anhydrides such as itaconic anhydride, succinic anhydride, citraconic anhydride, dodecenylsuccinic anhydride, tricarbanylic anhydride, maleic anhydride, hexahydrophthalic anhydride, methyl tetrahydrophthalic anhydride, hymic anhydride, phthalic anhydride, pyromellitic anhydride, trimellitic anhydride, 1,2,3,4-butanetetracarboxylic dianhydride, 1,2,3,4-cyclopentanetetracarboxylic dianhydride, 3,4,3',4'-benzophenonetetracarboxylic dianhydride, ethylene glycol bis(trimellitate) dianhydride and glycerine tris(trimellitate) trianhydride.

These carboxylic acid based additives can be used alone or in admixture of two or more.

The carboxylic acid based additive is preferably added in an amount of not larger than 10 parts by weight based on 100 parts by weight of the copolymer (A).

Further, to the radiation sensitive resin composition in the present invention, a filler, a colorant, a viscosity modifier and the like can be added such that properties inherent in the radiation sensitive resin composition are not impaired, preferably such that the total amount of these additives constitutes 50 wt% or smaller of the whole composition to be obtained.

Specific examples of the above filler include silica, alumina, talc, bentonite, zirconium silicate, and granulated glass.

These fillers can be used alone or in admixture of two or more.

Further, specific examples of the above colorant include body pigments such as alumina white, clay, barium carbonate and barium sulfate; inorganic pigments such as zinc flower, lead white, chrome yellow, red lead, ultramarine blue, iron blue, titanium oxide, zinc chromate, red iron oxide and carbon black; organic pigments such as Brilliant Carmine 6B, Permanent Red 6B, Permanent Red R, Benzidine Yellow, Phthalocyanine Blue and Phthalocyanine Green; basic dyes such as magenta and rhodamine; direct dyes such as Direct Scarlet and Direct Orange; and acid dyes such as Roselyn and metanil yellow.

These colorants can be used alone or in admixture of two or more.

Further, specific examples of the above viscosity modifier include bentonite, silica gel, and aluminum powder.

These viscosity modifiers can be used alone or in admixture of two or more.

The radiation sensitive resin composition in the present invention is preferably prepared as a liquid composition by uniformly mixing the copolymer (A), the polymerizable unsaturated compound (B), the photopolymerization initiator (C), the thermal polymerizable compound (D) and additives to be used as required and diluting the resulting mixture with an organic solvent so as to facilitate application of the composition onto a substrate.

The above organic solvent is preferably an organic solvent which can dissolve or disperse the components constituting the radiation sensitive resin composition uniformly, does not react with these components and has moderate volatility.

Specific examples of such an organic solvent include, in addition to the same solvents as those mentioned above with respect to polymerization of the above copolymer (A), high-boiling-point solvents such as N-methyl formamide, N,N-dimethyl formamide, N-methyl formanilide, N-methyl acetamide, N,N-dimethyl acetamide, N-methyl pyrrolidone, dimethyl sulfoxide, benzylethyl ether, dihexyl ether, acetonylacetone, isophorone, caproic acid, caprylic acid, 1-octanonal, 1-nonanol, benzyl alcohol, benzyl acetate, ethyl benzoate, diethyl oxalate, diethyl maleate, γ-butyrolactone, ethylene carbonate, propylene carbonate, and ethylene glycol monophenyl ether acetate.

Of these organic solvents, alkyl ethers of polyhydric alcohols such as ethylene glycol monoethyl ether and diethylene glycol monomethyl ether, alkyl ether acetates of polyhydric alcohols such as ethylene glycol monoethyl ether acetate, esters such as ethyl lactate, methyl 3-methoxypropoinate and ethyl 3-ethoxypropoinate, and ketones such as diacetone alcohol are preferred from the viewpoints of solubility, reactivity with the components and ease of formation of the coating film.

The above organic solvents can be used alone or in admixture of two or more.

The amount of the organic solvent can be selected as appropriate according to a specific application of the radiation sensitive resin composition for forming a microlens and a coating method of the composition.

To prepare the radiation sensitive resin composition in the present invention, the components thereof are simply stirred and mixed in the usual manner when a filler and a pigment are not added, while the components are dispersed and mixed by use of a disperser such as a dissolver, homogenizer or three-roll mill when a filler and a pigment are added. Further, before use, the radiation sensitive resin composition in the present invention may be filtered by use of a mesh, a membrane filter or the like as required after its preparation.

The radiation sensitive resin composition of the present invention can be very suitably used particularly for formation of a microlens for a liquid crystal display device, preferably as a liquid composition or a radiation sensitive dry film.

### Microlens

The microlens of the present invention is formed from the above radiation sensitive resin composition.

The microlens of the present invention can be very suitably used in a liquid crystal display device for various OA equipment, liquid crystal televisions, portable telephones and projectors, imaging optics of an on-chip color filter for a facsimile, an electronic copying machine and a solid-state image sensor, a fiber-optic connecter and the like.

### Radiation Sensitive Dry Film

The radiation sensitive dry film of the present invention is formed by laminating a radiation sensitive layer comprising the radiation sensitive resin composition of the present invention on a base film, preferably a flexible base film.

The radiation sensitive dry film can be formed by laminating the radiation sensitive layer on a base film by applying the radiation sensitive resin composition on the base film preferably as a liquid composition and drying the applied composition.

As the base film of the radiation sensitive dry film, a synthetic resin film such as a polyethylene terephthalate (PET) film, polyethylene, polypropylene, polycarbonate or polyvinyl chloride can be used.

The thickness of the base film is suitably 15 to 125 µm.

A coating method when the radiation sensitive layer is laminated on the base film is not particularly limited. For example, an appropriate method such as applicator coating, bar coating, roll coating or curtain flow coating can be employed.

The film thickness of the radiation sensitive layer to be obtained is preferably about 10 to 30 µm.

Further, when the radiation sensitive dry film is not in use, it can be stored with a cover film laminated on the radiation sensitive layer.

This cover film is used for stable protection of the radiation sensitive layer when the radiation sensitive dry film is not in use and removed when the radiation sensitive dry film is used. Thus, the cover film must have moderate removability so that it does not come off when the radiation sensitive dry film is not in use and can be removed easily when the radiation sensitive dry film is used. As a cover film which satisfies such a condition, a film prepared by applying or baking a silicone based releasing agent on the surface of a synthetic resin film such as a PET film, polypropylene film, polyethylene film or polyvinyl chloride can be used.

A satisfactory thickness of the cover film is generally about 25 µm.

### Method for Forming Microlens

The method for forming the microlens of the present invention carries out at least the following steps (i) to (iv) in the following order in which they are presented:
(i) forming a coating film of the above radiation sensitive resin composition for forming a microlens on a substrate,
(ii) irradiating (hereinafter referred to as "exposure") at least a portion of the coating film with radiation,
(iii) developing the exposed coating film, and
(iv) heat-treating (hereinafter referred to as "baking") the developed coating film to produce a microlens.

Hereinafter, these steps will be described.

### - Step (i) -

In this step, a method using the radiation sensitive resin composition as a liquid composition or a method using the radiation sensitive resin composition as a radiation sensitive dry film (hereinafter referred to as "dry film method") can be used.

When the radiation sensitive resin composition is used as a liquid composition, the liquid composition is applied on a substrate and then prebaked to form a coating film.

Illustrative examples of substrates that can be used include a glass substrate, a silicon wafer, and substrates resulting from forming various metal layers on the surfaces of the glass substrate and the silicon wafer.

A method of applying the liquid composition is not particularly limited. For example, an appropriate method such as spray coating, roll coating, spin coating or bar coating can be employed.

Conditions for prebaking vary according to the kinds and amounts of the components of the radiation sensitive resin composition. Prebaking is generally conducted at 60 to 130°C for about 30 seconds to 15 minutes.

The film thickness of the coating film to be obtained is preferably about 10 to 30 µm as a value after prebaking.

Meanwhile, in the case of the dry film method, a cover film is removed if it is laminated, a radiation sensitive dry film is applied to a substrate on the radiation sensitive layer side thereof, and the radiation sensitive dry film is compression-bonded to the substrate by applying appropriate heat and pressure by use of an appropriate compression-bonding method such as an atmospheric pressure heat roll compression-bonding method, a vacuum heat roll compression-bonding method or a vacuum heat press compression-bonding method. As a result, the radiation sensitive layer is transferred on the surface of the substrate, and a coating film of the radiation sensitive resin composition is formed on the substrate.

### - Step (ii) -

In this step, at least a portion of the formed coating film is exposed to radiation through a mask of predetermined pattern.

The radiation used for exposure is not particularly limited. For instance, ultraviolet radiation such as g radiation (wavelength: 436 nm) or i radiation (wavelength: 365 nm), fat ultraviolet radiation such as KrF eximer laser, an X-ray such as synchrotron radiation or a charged particle beam such as an electron beam is selected as appropriate according to the kind of the photopolymerization initiator (B) to be used and the like.

Of these radiations, ultraviolet radiation is preferred, and radiation including g radiation and/or i radiation is particularly preferred.

Further, light exposure is preferably about 50 to 10,000 J/m².

When the dry film method is used in the step (i), a base film used in the radiation sensitive dry film may be removed before exposure, or after exposure and before development.

### - Step (iii) -

In this step, the exposed coating film is developed by a developer, preferably an alkali developer, to remove unexposed portions, so as to form a pattern of predetermined shape.

Illustrative examples of the above alkali developer include aqueous solutions of basic compounds such as sodium hydroxide, potassium hydroxide, sodium carbonate, sodium silicate, sodium metasilicate, ammonia, ethylamine, n-propylamine, diethylamine, diethylaminoethanol, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5.4.0]-7-undecene, and 1,5-diazabicyclo[4.3.0]-5-nonene.

To the aqueous solution of the above basic compound, a proper amount of a water-soluble organic solvent such as methanol or ethanol or a surfactant can be added.

The coating film developed by the alkali developer is generally washed by, for example, running water.

Further, in the case of a radiation sensitive resin composition containing no insoluble components such as a pigment and a filler, various organic solvents which dissolve components constituting the composition can be used as developers.

As a development method, an appropriate method such as liquid feeding, dipping, rocking immersion or showering can be employed.

Development time varies according to the composition of the radiation sensitive resin composition. It is about 30 to 300 seconds at room temperature, for example.

In the case of a conventional radiation sensitive resin composition used to form a microlens, development time must be strictly controlled because a formed pattern comes off if the development time goes over the optimum condition by about 20 to 25 seconds. Meanwhile, in the case of the radiation sensitive resin composition in the present invention, a good pattern can still be formed even if the optimum development time is gone over by 30 seconds or more. Thus, the radiation sensitive resin composition in the present invention is advantageous in terms of product yield.

### - Step (iv) -

In this step, the developed coating film is baked by a heating device such as a hot plate or oven to cure the coating film, thereby forming a microlens.

Conditions for baking vary according to the kinds and amounts of the constituents of the radiation sensitive resin composition, a desired pattern shape and a heating device. In the case of a hot plate, baking is carried out at 150 to 240°C for about 1 to 30 minutes, and in the case of an oven, baking is carried out at 150 to 240°C for about 3 to 90 minutes, for example. When a substrate having low heat resistance such as a resin substrate is used, the temperature of baking is desirably 160°C or lower, preferably 100 to 150°C. Further, for baking, a step baking process comprising carrying out a heat treatment two or more times can be employed.

As described above, the radiation sensitive resin composition of the present invention can form a high-definition microlens and microlens array having a high resolution, excellent storage stability and coatability, and an excellent property balance.

Further, the microlens of the present invention shows an excellent balance in properties such as a film thickness, a resolution, a pattern shape, transparency, heat resistance, thermal discoloration resistance and solvent resistance. In particular, it can be very suitably used in a liquid crystal display device for various OA equipment, liquid crystal televisions, portable telephones and projectors.

Further, according to the method of the present invention for forming a microlens, a high-definition microlens and microlens array having excellent properties can be formed by a simple process. In addition, the method of the present invention for forming a microlens by the dry film method does not require time to determine conditions for obtaining a predetermined film thickness and is free of an environmental problem such as evaporation of organic solvent.

### Examples

Hereinafter, the present invention will be further described with reference to Examples and Comparative Examples. However, the present invention shall not be limited to the following Examples.

### Synthesis Example 1

After a flask equipped with a dry ice/methanol based reflux device was substituted with nitrogen, 4.0 g of 2,2'-azobisisobutyronitrile as a radical polymerization initiator and 100.0 g of diethylene glycol dimethyl ether and 50.0 g of diethylene glycol monomethyl ether as solvents were charged into the flask, and they were stirred until the radical polymerization initiator was dissolved. Then, 15.0 g of methacrylic acid, 15.0 g of 2-mono(hexahydrophthaloyloxy)ethyl methacrylate, 40.0 g of dicyclopentanyl methacrylate, 15.0 g of styrene and 15.0 g of tetrahydrofurfuryl methacrylate were added, and the resulting mixture was stirred slowly. Then, the temperature of the reaction solution was raised to 80°C, and polymerization was carried out at this temperature for 4 hours. After polymerization, the reaction solution was added dropwise into a large amount of methanol to solidify a reaction product. After rinsed with water, the obtained solidified product was dissolved in tetrahydrofuran having the same weight as that of the solidified product, and the resulting solution was added dropwise into a large amount of methanol to solidify a reaction product. After this redissolution-solidification operation was repeated for a total of three times, the reaction product was vacuum-dried at 40°C for 48 hours to obtain a copolymer (A).

This copolymer (A) will be referred to as "copolymer (A-1)".

### Synthesis Example 2

After a flask equipped with a dry ice/methanol based reflux device was substituted with nitrogen, 4.0 g of 2,2'-azobis-2,4-dimethylvaleronitrile as a radical polymerization initiator and 100.0 g of diethylene glycol diethyl ether and 150.0 g of ethyl lactate as solvents were charged into the flask, and they were stirred until the radical polymerization initiator was dissolved. Then, 10.0 g of methacrylic acid, 15.0 g of 2-mono(hexahydrophthaloyloxy)ethyl methacrylate, 40.0 g of dicyclopentanyl methacrylate, 15.0 g of styrene and 20.0 g of tetrahydrofurfuryl methacrylate were added, and the resulting mixture was stirred slowly. Then, the temperature of the reaction solution was raised to 80°C, and polymerization was carried out at this temperature for 4 hours. After polymerization, the reaction solution was added dropwise into a large amount of methanol to solidify a reaction product. After rinsed with water, the obtained solidified product was dissolved in tetrahydrofuran having the same weight as that of the solidified product, and the resulting solution was added dropwise into a large amount of methanol to solidify a reaction product. After this redissolution-solidification operation was repeated for a total of three times, the reaction product was vacuum-dried at 40°C for 48 hours to obtain a copolymer (A).

This copolymer (A) will be referred to as "copolymer (A-2)".

### Synthesis Example 3

After a flask equipped with a dry ice/methanol based reflux device was substituted with nitrogen, 4.0 g of 2,2'-azobisisobutyronitrile as a radical polymerization initiator and 150.0 g of diacetone alcohol as a solvent were charged into the flask, and they were stirred until the radical polymerization initiator was dissolved. Then, 20.0 g of acrylic acid, 15.0 g of 2-mono(hexahydrophthaloyloxy)ethyl methacrylate, 40.0 g of dicyclopentanyl methacrylate, 15.0 g of styrene and 5.0 g of isoprene were added, and the resulting mixture was stirred slowly. Then, the temperature of the reaction solution was raised to 80°C, and polymerization was carried out at this temperature for 4 hours. After polymerization, the reaction solution was added dropwise into a large amount of methanol to solidify a reaction product. After rinsed with water, the obtained solidified product was dissolved in tetrahydrofuran having the same weight as that of the solidified product, and the resulting solution was added dropwise into a large amount of methanol to solidify a reaction product. After this redissolution-solidification operation was repeated for a total of three times, the reaction product was vacuum-dried at 40°C for 48 hours to obtain a copolymer (A).

This copolymer (A) will be referred to as "copolymer (A-3)".

### Synthesis Example 4

After a flask equipped with a dry ice/methanol based reflux device was substituted with nitrogen, 4.0 g of 2,2'-azobis-2,4-dimethylvaleronitrile as a radical polymerization initiator and 150.0 g of ethyl 3-ethoxypropionate as a solvent were charged into the flask, and they were stirred until the radical polymerization initiator was dissolved. Then, 15 g of methacrylic acid, 15.0 g of 2-mono(hexahydrophthaloyloxy)ethyl methacrylate, 45.0 g of dicyclopentanyl methacrylate, 15.0 g of styrene and 10.0 g of isoprene were added, and the resulting mixture was stirred slowly. Then, the temperature of the reaction solution was raised to 80°C, and polymerization was carried out at this temperature for 4 hours. After polymerization, the reaction solution was added dropwise into a large amount of methanol to solidify a reaction product. After rinsed with water, the obtained solidified product was dissolved in tetrahydrofuran having the same weight as that of the solidified product, and the resulting solution was added dropwise into a large amount of methanol to solidify a reaction product. After this redissolution-solidification operation was repeated for a total of three times, the reaction product was vacuum-dried at 40°C for 48 hours to obtain a copolymer (A).

This copolymer (A) will be referred to as "copolymer (A-4)".

### Synthesis Example 5

After a flask equipped with a dry ice/methanol based reflux device was substituted with nitrogen, 4.0 g of 2,2'-azobisisobutyronitrile as a radical polymerization initiator and 150 g of methyl 3-methoxypropionate as a solvent were charged into the flask, and they were stirred until the radical polymerization initiator was dissolved. Then, 20 g of methacrylic acid, 15 g of 2-mono(hexahydrophthaloyloxy)ethyl methacrylate, 45 g of dicyclopentanyl methacrylate, 15.0 g of styrene and 5.0 g of 1,3-butadiene were added, and the resulting mixture was stirred slowly. Then, the temperature of the reaction solution was raised to 80°C, and polymerization was carried out at this temperature for 4 hours. After polymerization, the reaction solution was added dropwise into a large amount of methanol to solidify a reaction product. After rinsed with water, the obtained solidified product was dissolved in tetrahydrofuran having the same weight as that of the solidified product, and the resulting solution was added dropwise into a large amount of methanol to solidify a reaction product. After this redissolution-solidification operation was repeated for a total of three times, the reaction product was vacuum-dried at 40°C for 48 hours to obtain a copolymer (A).

This copolymer (A) will be referred to as "copolymer (A-5)".

### Synthesis Example 6

After a flask equipped with a dry ice/methanol based reflux device was substituted with nitrogen, 4.0 g of 2,2'-azobisisobutyronitrile as a radical polymerization initiator and 150 g of methyl 3-methoxypropionate as a solvent were charged into the flask, and they were stirred until the radical polymerization initiator was dissolved. Then, 15 g of methacrylic acid, 15 g of 2-mono(hexahydrophthaloyloxy)ethyl methacrylate, 45 g of dicyclopentanyl methacrylate, 15.0 g of styrene and 10.0 g of 1,3-butadiene were added, and the resulting mixture was stirred slowly. Then, the temperature of the reaction solution was raised to 80°C, and polymerization was carried out at this temperature for 4 hours. After polymerization, the reaction solution was added dropwise into a large amount of methanol to solidify a reaction product. After rinsed with water, the obtained solidified product was dissolved in tetrahydrofuran having the same weight as that of the solidified product, and the resulting solution was added dropwise into a large amount of methanol to solidify a reaction product. After this redissolution-solidification operation was repeated for a total of three times, the reaction product was vacuum-dried at 40°C for 48 hours to obtain a copolymer (A).

This copolymer (A) will be referred to as "copolymer (A-6)".

### Example 1

### Preparation of Liquid Composition

10.0 g of the copolymer (A-1) was dissolved in 10.0 g of methyl 3-methoxypropionate. Then, 5.0 g of LITE ACRYLATE 1.9-NDA as the polymerizable unsaturated compound (B), 2.0 g of 2,4,6-trimethylbenzoyldiphenyl phosphine oxide (trade name: LUCIRIN TPO) and 1.0 g of IRGACURE 651 as the photopolymerization initiator (C), and 2.0 g of EPIKOTE 828 as the thermal polymerizable compound (D) were added, and methyl 3-methoxypropionate was further added to prepare a solution having a solid concentration of 50 wt%. The obtained solution was filtered by use of a membrane filter having a pore diameter of 5 µm to prepare a liquid radiation sensitive resin composition (S-1).

### - Evaluation of Storage Stability -

The liquid composition (S-1) was stored in an oven at 40°C for one week, and the storage stability of the liquid composition (S-1) was evaluated by the rate (%) of increase of viscosity between its viscosity before storage and its viscosity after storage. The storage stability can be said to be good when the rate of increase of viscosity is within 5%. The evaluation result is shown in Table 1.

### Formation of Patterned Thin Film

After the liquid composition (S-1) was applied onto a glass substrate by use of a spinner, the applied composition was prebaked on a hot plate at 100°C for 5 minutes to prepare a coating film.

Then, the obtained coating film was irradiated with ultraviolet radiation whose intensity at a wavelength of 365 nm was 200 W/m² through a mask of predetermined pattern for 5 seconds. Then, the irradiated coating film was shower-developed by a 0.5-wt% tetramethylammonium hydroxide solution at 25°C for 2 minutes and then rinsed with pure water for one minute to form a pattern. Then, the coating film was baked in an oven at 220°C for 60 minutes to be cured. Thereby, a patterned thin film having a film thickness of 20.1 µm was obtained.

Then, the patterned thin film was evaluated in the following manner. The evaluation results are shown in Table 1.

### - Evaluation of Resolution -

The patterned thin film was rated as "O" when it could represent a pattern of line/space = 10 µm/10 µm, "Δ" when it could represent a pattern of line/space = 20 µm/20 µm, and "X" when it could represent neither of the above patterns.

### - Evaluation of Pattern Shape -

A pattern of line/space = 50 µm/50 µm or 30 µm/30 µm was observed for the patterned thin film under a transmission electron microscope. The patterned thin film was rated as "○" when it corresponded to the shape (a) in Fig. 1, "Δ" when it corresponded to the shape (b) in Fig. 1 , and "X" when it corresponded to the shape (c) in Fig. 1.

### - Evaluation of Transparency -

The transmission (%) at a wavelength of 400 nm of the patterned thin film was measured by spectrophotometer 150-20 type Double Beam (product of Hitachi, Ltd.) and evaluated. Transparency can be said to be good when the transmission is higher than 90%.

### - Evaluation of Heat Resistance -

The patterned thin film was heated in an oven at 220°C for 60 minutes, and its heat resistance was evaluated by the rate (%) of reduction in film thickness between its film thickness before heating and its film thickness after heating. The heat resistance can be said to be good when the rate of reduction in film thickness is within 5%.

### - Evaluation of Thermal Discoloration Resistance -

The patterned thin film was heated in an oven at 220°C for 60 minutes, the transmission at a wavelength of 400 nm of the patterned thin film was measured before and after heating by spectrophotometer 150-20 type Double Beam (product of Hitachi, Ltd.), and its thermal discoloration resistance was evaluated by the rate (%) of reduction in transmission. The thermal discoloration resistance can be said to be good when the rate of reduction in transmission is within 5%.

### - Evaluation of Solvent Resistance -

The glass substrate having the patterned thin film formed thereon was immersed in N-methyl pyrrolidone of 50°C for 15 minutes, and the solvent resistance of the film was evaluated by the rate (%) of change in film thickness between its film thickness before immersion and its film thickness after immersion [= (film thickness after immersion - film thickness before immersion) x 100/film thickness before immersion]. The solvent resistance can be said to be good when the rate of change in film thickness is within ±5%.

### Example 2

A liquid radiation sensitive resin composition (S-2) was prepared and a patterned thin film was formed and evaluated in the same manner as in Example 1 except that 2.0 g of bis[(3-ethyl-3-oxetanyl)methyl]terephthalate was used in place of 2.0 g of EPIKOTE 828. The evaluation results are shown in Table 1 together with the film thickness of the patterned thin film.

### Example 3

A liquid radiation sensitive resin composition (S-3) was prepared and a patterned thin film was formed and evaluated in the same manner as in Example 1 except that 2.0 g of [(3,4-epoxycyclohexyl)methyl]ester of 3,4-epoxycyclohexanecarboxylic acid was used in place of 2.0 g of EPIKOTE 828. The evaluation results are shown in Table 1 together with the film thickness of the patterned thin film.

### Example 4

A liquid radiation sensitive resin composition (S-4) was prepared and a patterned thin film was formed and evaluated in the same manner as in Example 1 except that 10.0 g of the copolymer (A-2) was used in place of 10.0 g of the copolymer (A-1) and 5.0 g of KAYARAD HDDA was used in place of 5.0 g of LITE ACRYLATE 1.9-NDA. The evaluation results are shown in Table 1 together with the film thickness of the patterned thin film.

### Example 5

A liquid radiation sensitive resin composition (S-5) was prepared and a patterned thin film was formed and evaluated in the same manner as in Example 1 except that 10.0 g of the copolymer (A-3) was used in place of 10.0 g of the copolymer (A-1) and 5.0 g of KAYARAD NPGDA was used in place of 5.0 g of LITE ACRYLATE 1.9-NDA. The evaluation results are shown in Table 1 together with the film thickness of the patterned thin film.

### Example 6

A liquid radiation sensitive resin composition (S-6) was prepared and a patterned thin film was formed and evaluated in the same manner as in Example 1 except that 10.0 g of the copolymer (A-4) was used in place of 10.0 g of the copolymer (A-1) and 5.0 g of ARONIX M8100 was used in place of 5.0 g of LITE ACRYLATE 1. 9-NDA. The evaluation results are shown in Table 1 together with the film thickness of the patterned thin film.

### Example 7

A liquid radiation sensitive resin composition (S-7) was prepared and a patterned thin film was formed and evaluated in the same manner as in Example 1 except that 10.0 g of the copolymer (A-5) was used in place of 10.0 g of the copolymer (A-1) and 5.0 g of ARONIX M8060 was used in place of 5.0 g of LITE ACRYLATE 1.9-NDA. The evaluation results are shown in Table 1 together with the film thickness of the patterned thin film.

### Example 8

A liquid radiation sensitive resin composition (S-8) was prepared and a patterned thin film was formed and evaluated in the same manner as in Example 1 except that 10.0 g of the copolymer (A-6) was used in place of 10.0 g of the copolymer (A-1) and 5.0 g of ARONIX M309 was used in place of 5.0 g of LITE ACRYLATE 1.9-NDA. The evaluation results are shown in Table 1 together with the film thickness of the patterned thin film.

### Example 9

The liquid radiation sensitive resin composition (S-1) was applied on a PET film having a thickness of 38 µm by use of an applicator, and the coating film was prebaked at 100°C for 5 minutes to prepare a radiation sensitive dry film comprising a radiation sensitive layer having a thickness of 25 µm. Then, the radiation sensitive dry film was placed on a surface of a glass substrate such that the radiation sensitive layer made contact with the surface, and the radiation sensitive dry film was compression-bonded to the glass substrate by a thermocompression bonding method to transfer the radiation sensitive dry film to the glass substrate.

Thereafter, a base film was removed from the radiation sensitive dry film on the substrate, and a patterned thin film was formed and evaluated in the same manner as in Example 1.

Transferability was evaluated in the following manner.

The evaluation results are shown in Table 1 together with the film thickness of the patterned thin film.

### - Evaluation of Transferability -

When the radiation sensitive dry film was transferred to the glass substrate and the base film was removed from the radiation sensitive dry film, the transferability of the radiation sensitive dry film was rated as "○" when the radiation sensitive layer could be transferred on the glass substrate uniformly and rated as "X" when the radiation sensitive layer could not be transferred on the glass substrate uniformly, e.g., when the radiation sensitive layer partially remained on the base film or the radiation sensitive layer did not stick to the surface of the glass substrate.

### Example 10

A radiation sensitive dry film was prepared in the same manner as in Example 9 except that the liquid radiation sensitive resin composition (S-2) was used in place of the liquid radiation sensitive resin composition (S-1).

Then, after a base film was removed from the radiation sensitive dry film on the substrate, a patterned thin film was formed and evaluated in the same manner as in Example 1, and transferability was evaluated in the same manner as in Example 9.

The evaluation results are shown in Table 1 together with the film thickness of the patterned thin film.

### Example 11

Storage stability was evaluated and a patterned thin film was formed and evaluated in the same manner as in Example 1 except that the liquid radiation sensitive resin composition (S-7) was used in place of the liquid radiation sensitive resin composition (S-1) and that the patterned thin film was baked on a hot plate at 150°C for 5 minutes to be cured.

The evaluation results are shown in Table 1 together with the film thickness of the patterned thin film.

### Example 12

A liquid radiation sensitive resin composition (S-9) was prepared in the same manner as in Example 1 except that 0.1 g of 2-benzyl-2-dimethylamino-1-(4-morpholinophenyl) butane-1-one was used as the component (C).

Then, the liquid radiation sensitive resin composition (S-9) was applied on a PET film having a thickness of 38 µm by use of an applicator, and the coating film was prebaked at 100°C for 5 minutes to prepare a radiation sensitive dry film comprising a radiation sensitive layer having a thickness of 25 µm. Then, the radiation sensitive dry film was placed on a surface of a glass substrate such that the radiation sensitive layer made contact with the surface, and the radiation sensitive dry film was compression-bonded to the glass substrate by a thermocompression bonding method to transfer the radiation sensitive dry film to the glass substrate.

Then, before a base film was removed from the radiation sensitive dry film on the substrate, the dry film was irradiated in the same manner as in Example 1, then the dry film was removed, and a patterned thin film was formed by development and evaluated in the same manner as in Example 1, and transferability was evaluated in the same manner as in Example 9.

The evaluation results are shown in Table 1 together with the film thickness of the patterned thin film.

### Example 13

A liquid radiation sensitive resin composition (S-10) was prepared in the same manner as in Example 7 except that 0.1 g of 2-benzyl-2-dimethylamino-1-(4-morpholinophenyl)buta ne-1-one was used as the component (C).

Then, the liquid radiation sensitive resin composition (S-10) was applied on a PET film having a thickness of 38 µm by use of an applicator, and the coating film was prebaked at 100°C for 5 minutes to prepare a radiation sensitive dry film comprising a radiation sensitive layer having a thickness of 25 µm. Then, the radiation sensitive dry film was placed on a surface of a glass substrate such that the radiation sensitive layer made contact with the surface, and the radiation sensitive dry film was compression-bonded to the glass substrate by a thermocompression bonding method to transfer the radiation sensitive dry film to the glass substrate.

Then, before a base film was removed from the radiation sensitive dry film on the substrate, the dry film was irradiated in the same manner as in Example 1, then the dry film was removed, and a patterned thin film was formed by development and evaluated in the same manner as in Example 1, and transferability was evaluated in the same manner as in Example 9.

The evaluation results are shown in Table 1 together with the film thickness of the patterned thin film.

### Example 14

10.0 g of the copolymer (A-1) as the component (A) was dissolved in 10.0 g of methyl 3-methoxypropionate. Then, 4.4 g of tricyclodecanyl methacrylate, 0.4 g of ARONIX M8100 and 0.2 g of KAYARAD R-526 as the component (B) and 2.0 g of 2,4,6-trimethylbenzoyldiphenyl phosphine oxide (trade name: LUCIRIN TPO) and 1.0 g of IRGACURE 651 as the component (C) were added, and methyl 3-methoxypropionate was further added to prepare a solution having a solid concentration of 50 wt% . The obtained solution was filtered by use of a membrane filter having a pore diameter of 5 µm to prepare a liquid radiation sensitive resin composition (S-11).

Then, storage stability was evaluated and a patterned thin film was formed and evaluated in the same manner as in Example 1 except that the liquid radiation sensitive resin composition (S-11) was used in place of the liquid radiation sensitive resin composition (S-1).

The evaluation results are shown in Table 1 together with the film thickness of the patterned thin film.

### Example 15

10.0 g of the copolymer (A-6) as the component (A) was dissolved in 10.0 g of methyl 3-methoxypropionate. Then, 4.4 g of tricyclodecanyl methacrylate, 0.4 g of ARONIX M9050 and 0. 2 g of KAYARAD R-604 as the component (B), 2.0 g of 2,4,6-trimethylbenzoyldiphenyl phosphine oxide (trade name: LUCIRIN TPO) and 1.0 g of IRGACURE 651 as the component (C) and 2.0 g of bis[(3-ethyl-3-oxetanyl)methyl]terephthalate as an additive were added, and methyl 3-methoxypropionate was further added to prepare a solution having a solid concentration of 50 wt%. The obtained solution was filtered by use of a membrane filter having a pore diameter of 5 µm to prepare a liquid radiation sensitive resin composition (S-12).

Then, storage stability was evaluated and a patterned thin film was formed and evaluated in the same manner as in Example 1 except that the liquid radiation sensitive resin composition (S-12) was used in place of the liquid radiation sensitive resin composition (S-1).

The evaluation results are shown in Table 1 together with the film thickness of the patterned thin film.

### Comparative Example 1

A liquid radiation sensitive resin composition (s-1) was prepared and a patterned thin film was formed and evaluated in the same manner as in Example 1 except that EPIKOTE 828 was not added. The evaluation results are shown in Table 1 together with the film thickness of the patterned thin film.

### Comparative Example 2

A liquid radiation sensitive resin composition (s-2) was prepared and a patterned thin film was formed in the same manner as in Example 7 except that EPIKOTE 828 was not added, and then the composition (s-2) was evaluated in the same manner as in Example 1. The evaluation results are shown in Table 1 together with the film thickness of the patterned thin film.

### Comparative Example 3

10.0 g of the copolymer (A-1) as the component (A) was dissolved in 10.0 g of methyl 3-methoxypropionate. Then, 3.0 g of KAYARAD HDDA and 2.0 g of KAYARAD R-526 as polymerizable unsaturated compounds and 2.0 g of 2,4,6-trimethylbenzoyldiphenyl phosphine oxide (trade name: LUCIRIN TPO) and 1.0 g of IRGACURE 651 as the component (C) were added, and methyl 3-methoxypropionate was further added to prepare a solution having a solid concentration of 50 wt% . The obtained solution was filtered by use of a membrane filter having a pore diameter of 5 µm to prepare a liquid radiation sensitive resin composition (s-3).

Then, a radiation sensitive dry film was prepared and transferred to a glass substrate in the same manner as in Example 9 except that the liquid radiation sensitive resin composition (s-3) was used in place of the liquid radiation sensitive resin composition (S-1) .

Then, after a base film was removed from the radiation sensitive dry film on the substrate, a patterned thin film was formed and evaluated in the same manner as in Example 1, and transferability was evaluated in the same manner as in Example 9.

The evaluation results are shown in Table 1 together with the film thickness of the patterned thin film.

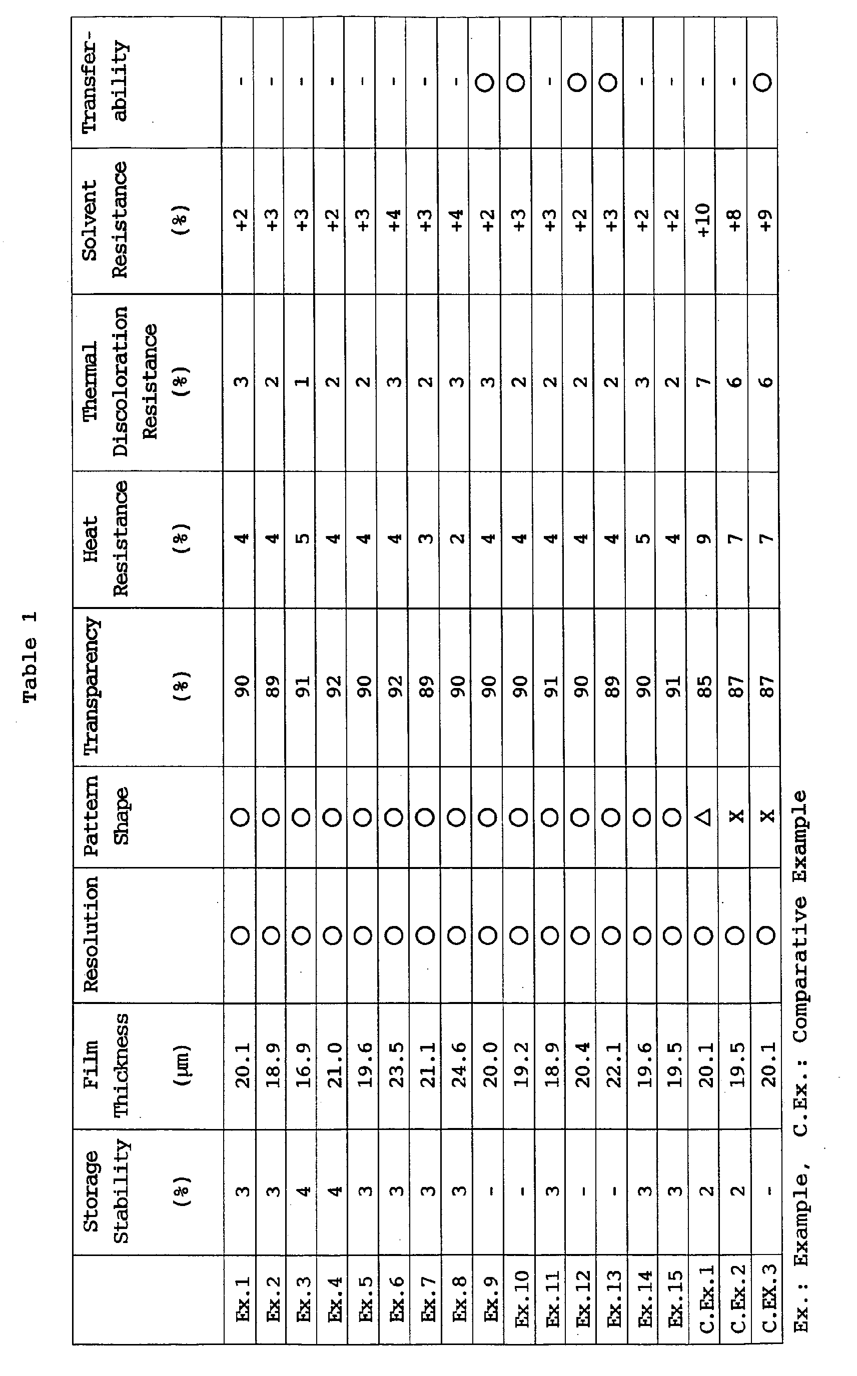

A radiation sensitive resin composition which contains (A) an alkali soluble polymer of a polymerizable mixture containing (a) 10 to 50 wt% of polymerizable unsaturated compound having an acid functional group, (b) 20 to 60 wt% of polymerizable unsaturated compound having an alicyclic hydrocarbon group and no acid functional group, and (c) 5 to 40 wt% of other polymerizable unsaturated compound, said wt% being based on the total of these components (a), (b) and (c),
(B) a polymerizable unsaturated compound,
(C) a photopolymerization initiator, and
(D) a thermal polymerizable compound. The composition is used for forming a microlens.

## Claims

1. A radiation sensitive resin composition for forming a microlens, the composition comprising:
(A) an alkali soluble polymer of a polymerizable mixture comprising:
(a) 10 to 50 wt% of polymerizable unsaturated compound having an acid functional group,
(b) 20 to 60 wt% of polymerizable unsaturated compound having an alicyclic hydrocarbon group and no acid functional group, and
(c) 5 to 40 wt% of other polymerizable unsaturated compound, said wt% being based on the total of these components (a), (b) and (c),
(B) a polymerizable unsaturated compound,
(C) a photopolymerization initiator, and
(D) a thermal polymerizable compound.

2. A microlens formed from the radiation sensitive resin composition of claim 1.

3. A radiation sensitive dry film formed by laminating a radiation sensitive layer comprising the radiation sensitive resin composition of claim 1 on a base film.

4. A method for forming a microlens which carries out the following steps (i) to (iv) in the following order in which they are presented:
(i) forming a coating film of the radiation sensitive resin composition of claim 1 on a substrate,
(ii) irradiating at least a portion of the coating film with radiation,
(iii) developing the irradiated coating film, and
(iv) heat-treating the developed coating film to produce a microlens.

5. The method of claim 4, wherein the temperature of the heat treatment in the step (iv) is 160°C or lower.

6. The method of claim 4 or 5, wherein in the step (i), the radiation sensitive layer of the radiation sensitive dry film of claim 3 is transferred onto the substrate to form the coating film of the radiation sensitive resin composition on the substrate.

7. A liquid crystal display device comprising the microlens of claim 2.
